# EUROPEAN PATENT SPECIFICATION

(11) **EP 4 269 669 B1**
(45) Date of publication and mention of the grant of the patent: **28.10.2026**
(21) Application number: 21910248.0
(22) Date of filing: 06.12.2021
(51) Int. Cl.: H10P 54/00, H10P 90/00, C30B 33/00, B28D 5/00, B23K 26/364, C30B 29/16

(54) **METHOD FOR PROCESSING GALLIUM OXIDE SUBSTRATE**
VERFAHREN ZUR VERARBEITUNG EINES GALLIUMOXIDSUBSTRATS
PROCÉDÉ DE TRAITEMENT DE SUBSTRAT D'OXYDE DE GALLIUM

(30) Priority: 24.12.2020 JP 2020214457
(43) Date of publication of application: 01.11.2023
(73) Proprietor: Mitsuboshi Diamond Industrial Co., Ltd., Settsu, Osaka 566-0034 (JP)
(72) Inventor: KITAICHI, Mitsuru, Settsu-city, Osaka 566-0034 (JP); ASAI, Yoshiyuki, Settsu-city, Osaka 566-0034 (JP); OKAMOTO, Hirokazu, Settsu-city, Osaka 566-0034 (JP); TSUJIMOTO, Yuki, Settsu-city, Osaka 566-0034 (JP)
(74) Representative: TBK
(86) International application number: PCT/JP2021/044626
(87) International publication number: WO 2022/138098

(56) References cited:
- JP-A- 2009 039 974
- JP-A- 2019 126 838
- US-A1- 2007 134 833

## Description

### TECHNICAL FIELD

The present invention relates to a method for processing a gallium oxide (Ga₂O₃) substrate, and more particularly to a substrate processing method capable of cutting a gallium oxide substrate into a lattice shape.

### BACKGROUND ART

Electronic devices produced by patterning a device region in a lattice shape on a semiconductor substrate or a glass substrate and cutting out each device region are used in a wide range of fields as products such as an optical device, a display device, a control device, and a power device. Among them, in a power semiconductor device used for power control or the like, a substrate material that can reduce power loss and has an excellent characteristic in withstand voltage performance is desirably used.

In performance evaluation of a substrate material used for a power semiconductor, Baliga's figure of merit (εµEc³: where ε is a dielectric constant, µ is electron mobility, and Ec is dielectric breakdown field strength) is used as one of figures of merit, and a material having a large index value of Baliga's figure of merit is evaluated as an excellent material as a power semiconductor. Comparison of Baliga's figures of merit of main semiconductor materials shows that in a case where Si is 1, SiC has a value of about 340, GaN has a value of about 870, and Ga₂O₃ has a value of 1500 to 3000, and SiC, GaN, and Ga₂O₃ are all attracting attention in the market as next-generation power semiconductor materials.

Among them, gallium oxide (Ga₂O₃) is excellent in Baliga' s figure of merit, and with gallium oxide having a β-gallia structure, it is possible to grow a high-quality bulk single crystal by a melt growth method such as an edge defined film fed growth (EFG) method, and therefore application as a power semiconductor material is particularly expected.

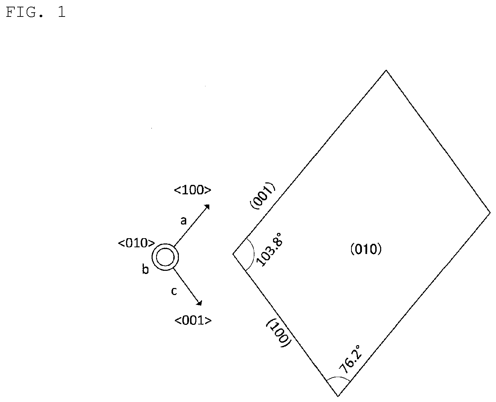

Gallium oxide having the β-gallia structure has an α-axis lattice constant of 12.2 Å, a b-axis lattice constant of 3.0 Å, and a c-axis lattice constant of 5.8 Å, an α angle (an angle formed by the b axis and the c axis) of 90°, a β angle (an angle formed by the c axis and the a axis) of 103.8°, and a γ angle (an angle formed by the a axis and the b axis) of 90°, and has a monoclinic crystal structure as illustrated in Fig. 1.

Further, in a gallium oxide single crystal having the β-gallia structure (hereinafter, gallium oxide having the β-gallia structure is simply abbreviated as gallium oxide), a plane (100) of the crystal structure exhibits particularly strong cleavage as a first cleavage plane, and then a plane (001) exhibits weak cleavage as a second cleavage plane.

In a melt growth method in which a seed crystal is brought into contact with a melt and grown, a large difference occurs in cleavage of a single crystal depending on a crystal plane (growth plane) brought into contact with the melt, and when a single crystal having strong cleavage is produced, there arises a problem that processability of a substrate is significantly impaired.

In view of the above, as a method for growing a gallium oxide crystal for solving the problem of impaired processability of a substrate, it is disclosed that when a crystal growth plane is the plane (001) with a pulling direction of a seed crystal at the time of crystal growth as a c-axis direction, and a single crystal is obtained by growing by an EFG method such that the plane (100) stands vertically, cleavage can be weakened, and the processability can be improved (see Patent Document 1).

By the method for growing a gallium oxide single crystal described in Patent Document 1, a single crystal grown in the c-axis direction is obtained. However, when the single crystal is subjected to circular punching and slicing to cut out a disk-shaped substrate (wafer), and orientation flat processing for forming an orientation flat indicating a crystal orientation, if the single crystal is cut out such that a main plane (substrate surface) is the plane (100), strong cleavage is still shown with the plane (100) as a cleavage plane, and a defect (chipping, cracking, or peeling) occurs.

In view of the above, in order to obtain a gallium oxide substrate in which no defect occurs, there have been disclosed a gallium oxide substrate in which a plane excluding (100) is set as a main plane of a circular gallium oxide substrate, and an orientation flat orthogonal to the main plane and the plane (100) is formed on a peripheral edge of the main plane such that first and second orientation flats are arranged point-symmetrically with a center point of the main plane as a symmetry point, and a method for manufacturing the gallium oxide substrate (see Patent Document 2).

In the gallium oxide substrate and the method for manufacturing the gallium oxide substrate described in Patent Document 2, the main plane may be any plane except for the plane (100), but specifically, it is described that it is preferable to use a plane (101), a plane (110), and a plane (111) as the main plane.

Further, as in Patent Document 2, as a method for manufacturing a disk-shaped gallium oxide substrate from an ingot of a gallium oxide single crystal while preventing occurrence of defects, there is disclosed a method in which a cylindrical block is cut out by wire electric discharge machining including orientation flat processing, and the cylindrical block is sliced to manufacture a gallium oxide substrate (see Patent Document 3).

In the gallium oxide substrate and the method for manufacturing the gallium oxide substrate described in Patent Document 3, it is described that the main plane is a plane different from the plane (100), for example, a plane (-201), a plane (101), and a plane (001). Further, it is described that when the main plane is the plane (001), homoepitaxial growth of a high-quality Ga₂O₃-based semiconductor layer is possible, and the gallium oxide substrate can be used as an excellent substrate for an electronic device.

Further, it is described that an orientation flat is preferably provided along a direction parallel to an intersection line between the main plane and the plane (100) and perpendicular to the main plane, and the number of orientation flats formed when a cylindrical block is cut out by wire electric discharge machining including orientation flat processing may be one (although two orientation flats may be formed). Patent document 4 discloses a method for processing a gallium oxide substrate by cutting a gallium oxide substrate having a β-gallia structure along an X direction and a Y direction orthogonal to each other on a main plane , the method comprising:-performing mechanical scribing processing in which a cut groove is engraved on the main plane by a blade edge of a scribing tool along a planned cutting line parallel to the X direction ;-performing laser scribing processing to be altered by scanning with a laser beam along a planned cutting line parallel to the Y direction ; and- performing break along planned cutting lines in the X direction and the Y direction after the mechanical scribing processing and after the laser scribing processing .

### PRIOR ART DOCUMENTS

### PATENT DOCUMENTS

Patent Document 1: Japanese Patent Laid-open Publication No. 2006-312571
Patent Document 2: Japanese Patent Laid-open Publication No. 2013-67524
Patent Document 3: Japanese Patent No. 5816343
Patent document 4: US2007134833.

### SUMMARY OF THE INVENTION

### PROBLEMS TO BE SOLVED BY THE INVENTION

As described in Patent Document 3, among substrates having a main plane (substrate surface) in a plane orientation different from the plane (100), a gallium oxide substrate having the plane (001) as the main plane is excellent as a substrate for an electronic device, and an excellent power device can be manufactured by using the gallium oxide substrate as a substrate for a power semiconductor device.

In a case where a power semiconductor device is patterned on a gallium oxide substrate, it is necessary to perform cutting for each device region without adversely affecting the device region (patterned region) as in conventional device processing formed on a Si substrate or a glass substrate. Therefore, a cutting process of performing cutting without adversely affecting the device region by mechanical scribing using a blade edge such as a cutter wheel or laser scribing by laser irradiation is required.

In a cutting process of a disk-shaped Si substrate, conventionally, the Si substrate is cut vertically and horizontally in a lattice shape based on an orientation flat. Specifically, a direction parallel to an intersection line between a main plane and an orientation flat plane is defined as an X direction, a direction orthogonal to the X direction on the main plane is defined as a Y direction, and cutting is performed in a lattice shape along the X direction and the Y direction.

However, it has been found that, since the gallium oxide substrate has the plane (100) of the first cleavage plane exhibiting strong cleavage, when an attempt is made to cut into a lattice shape by directly applying scribing similar to the cutting processing method established for Si substrates and glass substrates, it is difficult to perform cutting in a lattice shape as expected under the influence of the strong cleavage plane.

Specifically, there has occurred a problem that, in a case where cutting is attempted in the X direction and the Y direction by mechanical scribing, even in a case where a cut groove is formed on the main plane, if the cut groove is in a direction different from a direction of the cleavage plane, a crack does not penetrate in a thickness direction and cutting cannot be performed. Further, there has occurred a problem that, in a case of attempting to cut in the X direction and the Y direction by laser scribing, the position of a cut plane on the main plane is not fixed and cutting in accordance with a planned cutting line cannot be performed in many cases even though the laser is applied along the planned cutting line, and cutting with high processing accuracy cannot be performed.

Although it is conceivable to perform cutting vertically and horizontally by applying another cutting technique (for example, wire electric discharge machining) as described in Patent Document 3 and the like, there is a possibility that a device region is adversely affected in a substrate after the device region is patterned on the main plane. Furthermore, in order to mass-produce devices, it is necessary to consider processing time and processing cost required for cutting. Further, cutting is desirably able to be performed by applying a highly reliable processing technique that has been performed in cutting of Si substrates and glass substrates.

In view of the above, an object of the present invention is to provide a practical method for processing a gallium oxide substrate that enables a disk-shaped gallium oxide substrate to be cut vertically and horizontally in a lattice shape.

Further, an object of the present invention is to provide a processing method for cutting out a device region in a lattice shape for each device region on a disk-shaped gallium oxide substrate without affecting the device region in a case where the device region is patterned in a lattice shape on the disk-shaped gallium oxide substrate and the like.

### SOLUTIONS TO THE PROBLEMS

A method for processing a gallium oxide substrate according to the present invention made to solve the above problems is a method for processing a gallium oxide substrate by cutting a gallium oxide substrate having a β-gallia structure along an X direction and a Y direction orthogonal to each other on a main plane.

The method includes performing mechanical scribing processing in which a cut groove is engraved on the main plane by a blade edge of a scribing tool along a planned cutting line parallel to the X direction, which is defined as a direction parallel to an intersection line between the main plane and a plane (100), using a gallium oxide substrate of which the main plane is the plane (001), performing laser scribing processing to be altered by scanning with a laser beam along a planned cutting line parallel to the Y direction, and performing break along planned cutting lines in the X direction and the Y direction after the mechanical scribing processing and after the laser scribing processing.

Here, the "scribing tool" refers to a tool that has a sharp blade edge formed of a material having hardness higher than that of a substrate material such as diamond or a cemented carbide, and engraves a cut groove by performing scribing by scanning a substrate while pressing the blade edge against the substrate. The blade edge may be a rotary blade or a fixed blade.

As a laser light source used in the "laser scribing processing", a laser light source having a wavelength that can be absorbed by a gallium oxide substrate is used, but it is more preferable to select a laser wavelength or a lens optical system that is absorbed not only on a substrate surface but also inside the substrate as much as possible, and perform laser irradiation to be altered as far as a deep position in a thickness direction. Specifically, an infrared laser can be used as the laser light source.

In the "break" step, mechanical or thermal stress is applied along a planned cutting line after scribing. A method of applying stress is not particularly limited, but a break device conventionally used for break of a Si substrate or a glass substrate can be used. Specifically, it is also possible to use a mechanical break device that places a break bar on a back side of a planned cutting line to bend and cut a substrate, or it is also possible to use a break device that blows cold heat or heat to thermally perform break. Simple break such as bending a substrate by manual work or using a simple jig may be performed.

According to the present invention, when the main plane is scribed with a blade edge of the scribing tool along a planned cutting line parallel to the X direction to engrave a cut groove, since the X direction is a direction of an intersection line between the main plane and the plane (100), the cut groove is cleaved at the plane (100) including the cut groove, and cutting can be performed along the plane (100).

On the other hand, there is no plane orientation indicating cleavage in the Y direction orthogonal to the X direction. For this reason, even if scribing is performed in the Y direction by the scribing tool and a cut groove is engraved on the main plane, a crack does not penetrate. Even if an attempt is made to engrave a deep cut groove along the Y direction and perform cutting by force, a surface layer is peeled off or the substrate is broken.

In view of the above, in the Y direction, laser scribing processing in which scanning is performed with a laser beam along a planned cutting line to be thermally altered. By the above, from a substrate surface to the inside of the substrate, it is possible to alter so as to weaken coupling between crystal lattices on a plane having no cleavage, and it is possible to perform cutting along a vertical plane locally altered by being irradiated with a laser beam immediately below a planned cutting line.

Note that, when irradiation with a laser beam is performed along a planned cutting line in the X direction, cleavage occurs along a cleavage plane of the plane (100) in this case, but a starting position of cleavage is not limited to a position on the planned cutting line of the main plane, and cleavage may occur at a position deviated from the planned cutting line in the vicinity of a laser irradiation position. Therefore, it is not possible to accurately perform cutting along the planned cutting line, and processing accuracy is significantly deteriorated.

### EFFECTS OF THE INVENTION

According to the present invention, using a substrate in which orientations of a main plane and a cutting direction are specified, mechanical scribing processing is performed by a scribing tool in an X direction, and laser scribing processing is performed in a Y direction orthogonal to the X direction. Therefore, cutting can be performed using cleavage in the X direction (in a direction substantially perpendicular to the main plane at an inclination of about 14° with respect to an XY plane (main plane)), and cutting can be performed in the Y direction so as to weaken coupling between crystal lattices with respect to a direction without a cleavage plane, and it is possible to perform processing of accurately cutting the main plane of the gallium oxide substrate in the X direction and the Y direction orthogonal to each other.

In the above invention, in the laser scribing processing for a planned cutting line parallel to the Y direction, scanning with the laser beam may be repeated a plurality of times for one planned cutting line.

By repeating the scanning with a laser beam a plurality of times, it is possible to further weaken coupling between crystal lattices at a position through which the laser beam passes inside the substrate as the number of times of scanning increases, and it is possible to more easily perform subsequent break processing in the Y direction. In a case where thickness of the substrate is increased, ease of cutting in the Y direction can be adjusted by increasing the number of times of scanning with the laser beam according to the thickness.

Further, by using the method for processing a gallium oxide substrate described above, processing may be performed into a parallelepiped shape in which the main plane is a plane (001), a side plane in the X direction is a plane (100) obliquely intersecting the main plane (at a theoretical angle of 103.8°), a side plane in the Y direction is a plane orthogonal to the main plane and the side plane in the X direction, and the main plane has a rectangular shape.

According to the present invention, when cutting is performed using cleavage in the X direction, cutting can be performed into a parallelepiped shape in which the main plane and the back plane are rectangular (including square).

In a conventional device manufacturing process using a Si substrate, a main plane of a substrate is scribed in an XY direction to be cut out into a rectangular parallelepiped shape. However, even in a gallium oxide substrate of the present invention, the main plane can be scribed in the XY direction to be cut out into a parallelepiped shape close to a rectangular parallelepiped shape. Therefore, a device processing technique conventionally employed for a Si substrate can be almost directly applied to device processing on a gallium oxide substrate.

### BRIEF DESCRIPTION OF THE DRAWINGS

Fig. 1 is a view for explaining a plane orientation and a crystal axis of a gallium oxide crystal having a β-gallia structure which is a monoclinic system.
Fig. 2 is a view ((a) a plan view, (b) a front view, and (c) a right side view) for explaining a crystal orientation of an orientation flat and a plane orientation index of a gallium oxide substrate used in the present invention.
Fig. 3 is a view illustrating a planned cutting line in an X direction and a Y direction for cutting the gallium oxide substrate according to the present invention.
Figs. 4(a) and 4 (b) are enlarged views illustrating a cut plane obtained by mechanical scribing processing in the X direction, in which Fig. 4(a) is a cross-sectional photograph viewed from the front, and Fig. 4(b) is a cross-sectional photograph viewed from the side.
Figs. 5(a) and 5(b) are enlarged views illustrating a cut plane obtained by laser scribing processing in the X direction, in which Fig. 5(a) is a cross-sectional photograph viewed from the front, and Fig. 5(b) is a cross-sectional photograph viewed from the side.
Fig. 6 is an enlarged photograph of a main plane obtained by laser scribing processing in the X direction taken from above.
Figs. 7 (a) and 7 (b) are enlarged views illustrating a cut plane obtained by laser scribing processing in the Y direction, in which Fig. 7 (a) is a cross-sectional photograph viewed from the front, and Fig. 7 (b) is a cross-sectional photograph viewed from the side.

### EMBODIMENT OF THE INVENTION

### (Orientation index of orientation flat and plane orientation index of gallium oxide substrate)

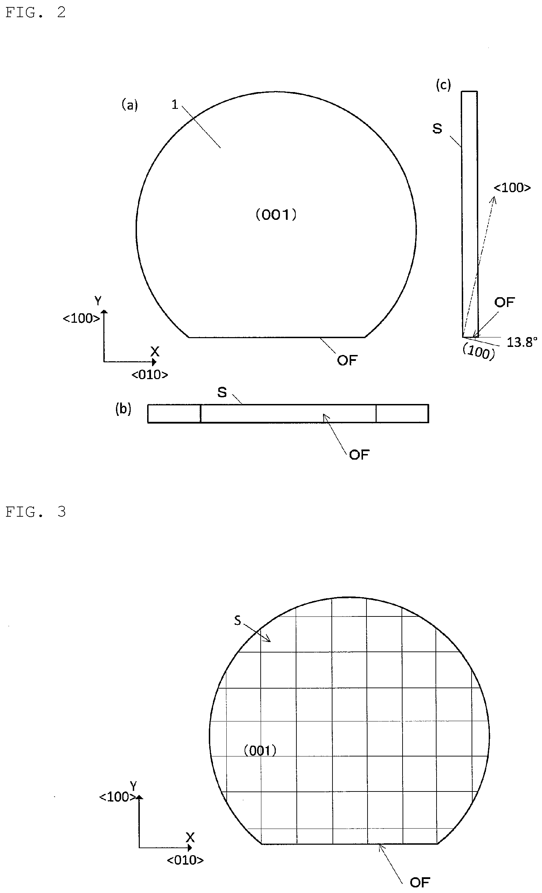

Hereinafter, an embodiment of the present invention will be described with reference to the drawings. Fig. 2 is a view illustrating a crystal orientation of an orientation flat and a plane orientation index of a gallium oxide substrate used in a substrate processing method of the present invention.

In a disk-shaped gallium oxide substrate 1, a plane orientation of a main plane S to be a substrate surface and a substrate back surface is (001). Further, an orientation flat is a plane along a direction parallel to an intersection line L between a plane (001) which is the main plane S and a plane (100), and a plane perpendicular to the main plane S is formed as an orientation flat OF. Therefore, the plane (100) is inclined at a theoretical angle of 13.8° from the orientation flat OF.

Note that a method for manufacturing the substrate in which the orientation of the main plane S and the orientation flat OF is defined in this manner is not particularly limited, but for example, the substrate can be manufactured by the manufacturing method described in Patent Document 3.

### (Cutting processing verification experiment)

Hereinafter, a verification experiment of the present invention will be described. A direction parallel to the intersection line L between the main plane S and the plane (100), that is, a direction (orientation index <010>) parallel to an intersection line between the main plane S and the orientation flat OF is defined as an X direction, a direction orthogonal to the X direction on the main plane S is defined as a Y direction, and as illustrated in Fig. 3, processing of cutting into a lattice shape along planned cutting lines in the X direction and the Y direction set on the main plane S was performed. The thickness of the substrate was 0.7 mm.

### (Mechanical scribing processing in X direction)

For processing in the X direction, mechanical scribing processing was performed using a scribing tool as a first step to form a cut groove on the main plane S, and then break processing of mechanically applying stress along the planned cutting line was performed as a second step. Scribing conditions are as described below.
Scribing tool: Cutter wheel (rotary blade)
Scribing load: 0.1 MPa
Scribing speed: 100 mm/s

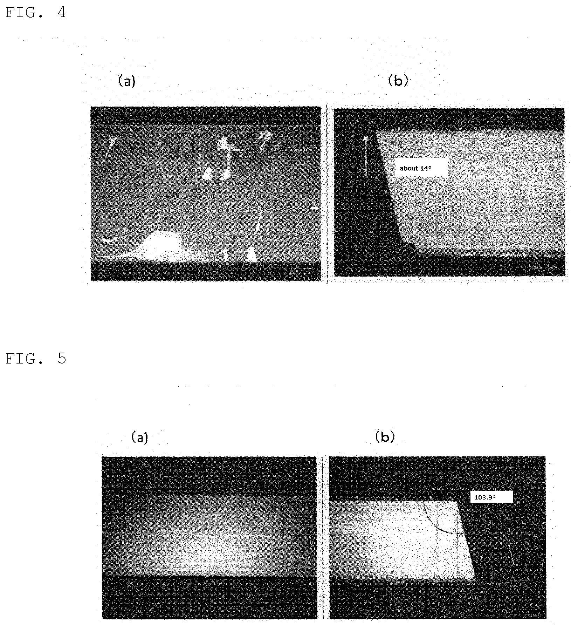

As a result, it was possible to perform cutting on the planned cutting line of the main plane S as a starting point. Fig. 4(a) is a cross-sectional photograph of a cut plane as viewed from the front, and Fig. 4(b) is a cross-sectional photograph of a cut plane as viewed from the side. The cut plane was inclined at an angle of about 104° with respect to the main plane S (about 14° with respect to the orientation flat plane) (an oblique break was generated), and cutting could be performed along a cleavage plane of the plane (100). Further, cutting could be performed similarly also in a case where the scribing load was set to 0.05 MPa to 0.2 MPa.

### (Mechanical scribing processing in Y direction)

For processing in the Y direction, similarly to that in the X direction, mechanical scribing processing with a scribing tool was performed in a first step, and then break processing of mechanically applying stress along a planned cutting line was performed in a second step. Scribing conditions are as described below.
Scribing tool: Cutter wheel (rotary blade)
Scribing load: 0.1 MPa
Scribing speed: 100 mm/s

As a result, cutting could not be performed at all. When the scribing load was increased in an attempt to deepen a cut groove, peeling of the main plane S (surface layer) occurs. Since there was no cleavage plane in the Y direction, the crack could not penetrate in the thickness direction, and cutting along the planned cutting line could not be performed.

### (Laser scribing processing in X direction)

Processing in the X direction was performed by laser scribing processing with an infrared laser in a first step, and then break processing of mechanically applying stress along a planned cutting line was performed in a second step. Scribing conditions are as described below.
Laser light source: Infrared laser
Oscillation wavelength: 1064 nm
Lens optical system: Combination lens (multi-focus lens)

As a result, it was possible to cut with a flat cut plane. Fig. 5(a) is a cross-sectional photograph of a cut plane as viewed from the front, and Fig. 5(b) is a cross-sectional photograph of a cut plane as viewed from the side. The cut plane was inclined at an angle of about 103.9° with respect to the main plane S (an oblique break was generated), and cutting could be performed along a cleavage plane of the plane (100).

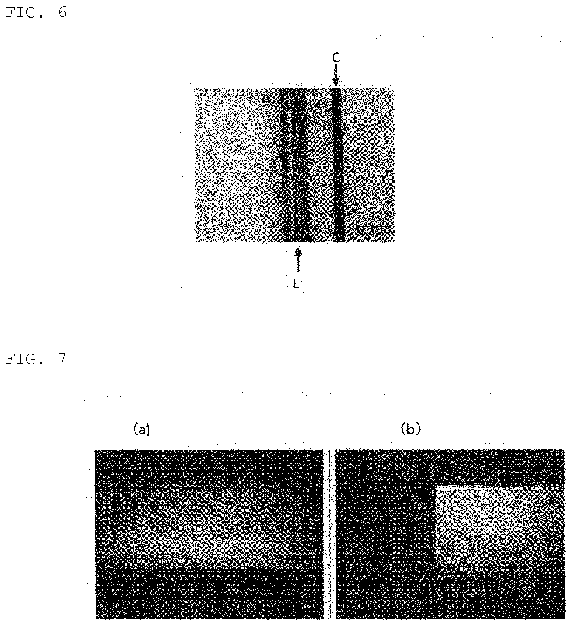

However, in many cases, the position of the cut plane on the main plane S deviated from the planned cutting line in parallel in cutting, and the position of the cut plane was not fixed. Fig. 6 is a plane photograph of the main plane S taken from above. A scribe line L (the same line as the planned cutting line), which is a trace of laser irradiation on the main plane S, and a cutting line C actually cut on the main plane S are misaligned in parallel.

This phenomenon is considered to occur because the position of the cut plane is not fixed since the position of occurrence of a starting point crack that determines the cut plane stochastically changes due to a positional relationship between a portion with weak lattice coupling that irregularly exists inside the substrate and a position where a laser beam passes through the substrate. Therefore, in the scribing processing in the X direction by laser irradiation, cutting along the planned cutting line could not be accurately performed.

### (Laser scribing processing in Y Direction)

Processing in the Y direction was performed by laser scribing processing with an infrared laser in the first step, and then break processing of mechanically applying stress along the planned cutting line was performed in the second step. Scribing conditions are as described below.
Laser light source: Infrared laser
Oscillation wavelength: 1064 nm
Lens optical system: Combination lens (multi-focus lens)

As a result, it was possible to cut with a flat cut plane. Fig. 7(a) is a cross-sectional photograph of a cut plane as viewed from the front, and Fig. 7(b) is a cross-sectional photograph of a cut plane as viewed from the side. As for the cut plane, cutting could be performed perpendicularly to the main plane S, and cutting could be performed in a direction where no cleavage plane exists. As for the position of the cut plane, cutting could be performed accurately along the planned cutting line.

In the laser scribing processing in the Y direction, when the number of times of scanning of laser scribing is increased to a plurality of times, cutting could be performed even if stress applied along the planned cutting line was reduced at the time of the break processing in the second step along with the increase in the number of times of scanning, and a tendency that the break processing could be easily performed as compared with a case where laser scribing was performed in only one time of scanning was observed. By reducing the stress applied at the time of the break processing, it is possible to reduce the possibility of inducing cleavage of the plane (001) which is the main plane at the time of break.

### (Summary of verification result)

Summarizing the above verification experiment result, by satisfying all of the following conditions, the main plane S could be cut in a lattice shape along the X and Y directions orthogonal to each other:
(a) using a gallium oxide substrate in which the main plane is the plane (001), and an orientation flat is formed along a plane (preferably a plane perpendicular to the main plane S) including a direction (<010> direction) parallel to an intersection line between the main plane and the plane (100);
(b) performing mechanical scribing processing in which a cut groove is engraved on the main plane S by using a scribing tool along a planned cutting line parallel to the X direction which is defined as the intersection line direction (<010> direction); and
(c) performing laser scribing processing in which scanning is performed with a laser beam along a planned cutting line parallel to the Y direction orthogonal to the X direction for alteration.

The substrate cut into a lattice shape from the main plane S by the above processing method can be cut out as a parallelepiped in which the main plane S (substrate surface) and the substrate back surface are the planes (001), a pair of side planes are the planes (010) perpendicular to the main plane S, and another pair of side planes are inclined at a theoretical angle of 103.8° with respect to the main plane S. Therefore, the substrate can be cut out into a substantially rectangular parallelepiped shape, and a conventional device processing technique for a Si substrate can be applied (used).

### INDUSTRIAL APPLICABILITY

The present invention can be used as a cutting processing method for a gallium oxide substrate suitable for a power device.

### DESCRIPTION OF REFERENCE SIGNS

1: Gallium oxide substrate
S: Main plane
OF: Orientation flat
C: Cut plane
L: Irradiation trace of laser scribing (planned cutting line)

## Claims

1. A method for processing a gallium oxide substrate by cutting a gallium oxide substrate having a β-gallia structure along an X direction and a Y direction orthogonal to each other on a main plane, the method comprising:
performing mechanical scribing processing in which a cut groove is engraved on the main plane by a blade edge of a scribing tool along a planned cutting line parallel to the X direction, which is defined as a direction parallel to an intersection line between the main plane and a plane (100), using a gallium oxide substrate of which the main plane is the plane (001);
performing laser scribing processing to be altered by scanning with a laser beam along a planned cutting line parallel to the Y direction; and
performing break along planned cutting lines in the X direction and the Y direction after the mechanical scribing processing and after the laser scribing processing.

2. The method for processing a gallium oxide substrate according to claim 1, wherein the laser scribing processing on the planned cutting line parallel to the Y direction repeats the scanning with the laser beam for one planned cutting line a plurality of times.

3. A method for processing a gallium oxide substrate using the method for processing a gallium oxide substrate according to any of claims 1 and 2, the method comprising:
processing into a parallelepiped shape in which the main plane is the plane (001), a side plane in the X direction is the plane (100) obliquely intersecting the main plane, a side plane in the Y direction is a plane orthogonal to the main plane and the side plane in the X direction, and the main plane has a rectangular shape.

## Patentansprüche

1. Verfahren zum Bearbeiten eines Galliumoxid-Substrats durch Schneiden eines Galliumoxid-Substrats mit einer β-Gallia-Struktur entlang einer X-Richtung und einer Y-Richtung, die zueinander orthogonal auf einer Hauptebene sind, wobei das Verfahren Folgendes aufweist:
Ausführen einer mechanischen Ritzbearbeitung, bei der mit einer Schneidkante eines Ritzwerkzeugs entlang einer geplanten Schnittlinie, die parallel zu der X-Richtung ist, die als eine Richtung definiert ist, die parallel zu einer Kreuzungslinie zwischen der Hauptebene und einer Ebene (100) ist, eine Schnittnut an der Hauptebene eingraviert wird, indem ein Galliumoxid-Substrat verwendet wird, dessen Hauptebene die Ebene (001) ist;
Ausführen einer Laser-Ritzbearbeitung zum Umändern durch Abtasten mit einem Laserstrahl entlang einer geplanten Schnittlinie, die parallel zu der Y-Richtung ist; und
Ausführen eines Bruchs entlang von geplanten Schnittlinien in der X-Richtung und der Y-Richtung nach der mechanischen Ritzbearbeitung und nach der Laser-Ritzbearbeitung.

2. Verfahren zum Bearbeiten eines Galliumoxid-Substrats nach Anspruch 1, wobei die Laser-Ritzbearbeitung an der geplanten Schnittlinie, die parallel zu der Y-Richtung ist, das Abtasten mit dem Laserstrahl für eine geplante Schnittlinie mehrmals wiederholt.

3. Verfahren zum Bearbeiten eines Galliumoxid-Substrats unter Verwendung des Verfahrens zum Bearbeiten eines Galliumoxid-Substrats nach einem der Ansprüche 1 und 2, wobei das Verfahren Folgendes aufweist:
Bearbeiten zu einer Parallelepipedform, bei der die Hauptebene die Ebene (001) ist, eine Seitenebene in der X-Richtung die Ebene (100) ist, die die Hauptebene schräg kreuzt, eine Seitenebene in der Y-Richtung eine Ebene ist, die orthogonal zu der Hauptebene und der Seitenebene in der X-Richtung ist, und die Hauptebene eine Rechteckform hat.

## Revendications

1. Procédé de traitement d'un substrat d'oxyde de gallium par découpe d'un substrat d'oxyde de gallium ayant une structure d'oxyde de gallium β le long d'une direction X et d'une direction Y orthogonales entre elles sur un plan principal, le procédé comprenant :
la réalisation d'un traitement de rainurage mécanique dans lequel une rainure découpée est gravée sur le plan principal par une arête de lame d'un outil de rainurage le long d'une ligne de coupe prévue parallèle à la direction X, qui est définie comme une direction parallèle à une ligne d'intersection entre le plan principal et un plan (100), au moyen d'un substrat d'oxyde de gallium dont le plan principal est le plan (001) ;
la réalisation d'un traitement de rainurage laser destiné à être modifié par balayage avec un faisceau laser le long d'une ligne de coupe prévue parallèle à la direction Y ; et
la réalisation d'une cassure le long de lignes de coupe prévues dans la direction X et la direction Y après le traitement de rainurage mécanique et après le traitement de rainurage laser.

2. Procédé de traitement d'un substrat d'oxyde de gallium selon la revendication 1, dans lequel le traitement de rainurage laser sur la ligne de coupe prévue parallèle à la direction Y répète le balayage avec le faisceau laser pour une ligne de coupe prévue une pluralité de fois.

3. Procédé de traitement d'un substrat d'oxyde de gallium utilisant le procédé de traitement d'un substrat d'oxyde de gallium selon l'une quelconque des revendications 1 et 2, le procédé comprenant :
la transformation en une forme parallélépipédique dans laquelle le plan principal est le plan (001), un plan latéral dans la direction X est le plan (100) croisant obliquement le plan principal, un plan latéral dans la direction Y est un plan orthogonal au plan principal et au plan latéral dans la direction X, et le plan principal a une forme rectangulaire.
